Europäisches Patentamt

European Patent Office

Office européen des brevets

(11) Publication number: **0 026 579**
**B1**

(12) **EUROPEAN PATENT SPECIFICATION**

(45) Date of publication of patent specification: **29.01.86**

(51) Int. Cl.⁴: **H 03 M 1/34,** H 03 M 1/46

(21) Application number: **80302979.2**

(22) Date of filing: **28.08.80**

(54) A digital-to-analog conversion system.

(30) Priority: **04.09.79 JP 113289/79**

(43) Date of publication of application:
**08.04.81 Bulletin 81/14**

(45) Publication of the grant of the patent:
**29.01.86 Bulletin 86/05**

(84) Designated Contracting States:
**DE FR GB NL**

(56) References cited:
**US-A-3 505 668**

**Patents Abstracts of Japan, vol. 1, no. 119, 11
October 1977, page 4829E77**

**1978 IEEE International Solid State Circuits
Conference, Session XIV, page 186**

**Elektronik 1965, H.5, page 151**

(73) Proprietor: **FUJITSU LIMITED**
**1015, Kamikodanaka Nakahara-ku
Kawasaki-shi Kanagawa 211 (JP)**

(72) Inventor: **Iwamoto, Hiromu
31-2-308, Hiragata-cho Kanazawa-ku,
Yokohama-shi Kanagawa 236 (JP)**
Inventor: **Tamada, Haruo
497-28-19-24, Kawakami-cho Totsuka-ku
Yokohama-shi Kanagawa 244 (JP)**

(74) Representative: **Abbott, Leonard Charles et al
GILL JENNINGS & EVERY 53-64 Chancery Lane
London WC2A 1HN (GB)**

Courier Press, Leamington Spa, England.

## Description

This invention relates to an analog-to-digital (A/D) conversion system including a digital-to-analog (D/A) converter. The system is of a step-by-step comparison type for processing signals in electronic circuit devices.

An example of a prior A/D conversion system of the above kind is disclosed in 1978 IEEE International Solid State Circuits Conference, page 186, "A Companding D/A Converter for a Dual-Channel PCM CODEC", E. Pfrenger, et al.

Another prior A/D conversion system including a D/A converter with a resistor ladder network is disclosed in United States Patent No. 3 505 668. That converter comprises a comparator to one input terminal of which the input analog signal is fed, and a register for producing binary data in response to the output of the comparator. The ladder network in the D/A converter has a plurality of series-connected first resistors of value R and a plurality of shunt-connected second resistors of value 2R. Switching elements are provided for connecting the free ends of the second resistors alternatively to a reference voltage source or to ground. The switches are controlled by a digital input signal from the register so that the ladder network produces an analog signal which is fed to the other input terminal of the comparator.

However, the D/A converters of the prior A/D conversion systems do not include any means for selecting the voltage level of the analog output of the D/A converter. This presents a problem in that, as the analog input signal level decreases, the response time of the comparator increases, so that the overall response time of the system increases correspondingly.

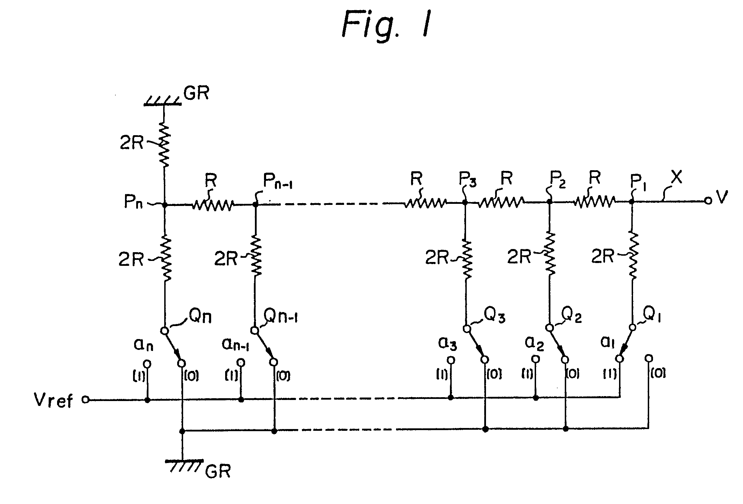

Another prior art D/A converter of a resistor ladder network type having a plurality of first resistors of resistance value R and a plurality of second resistors of resistance value 2R is illustrated in Figure 1 of the accompanying drawings. In the D/A converter of Figure 1, "$n-1$" first resistors of resistance value R are connected in series between a first terminal $P_1$ and a second terminal $P_n$, connection points $P_2$, $P_3$, ... $P_{n-1}$ being formed between successive pairs of adjacent resistors of resistance value R. One terminal of each of the "$n$" second resistors of resistance value 2R is connected to a respective one of the first terminal $P_1$, the connection points $P_2$, $P_3$, ... $P_{n-1}$ and the second terminal $P_n$. Another resistor of resistance value 2R is connected between the second terminal $P_n$ and ground GR. The other terminals $Q_1$, $Q_2$, ... $Q_n$ of the "$n$" second resistors are connected to fixed contacts of switching elements $a_1$, $a_2$, ... $a_n$. Switchable contacts of each of the switching elements $a_1$, $a_2$, ... $a_n$ consist of a function "1" contact which is connected to a reference voltage source $V_{ref}$, and a function "0" contact which is connected to the ground GR. Semiconductor switching elements may be used for the switching elements $a_1$, $a_2$, ... $a_n$.

The switching elements $a_1$, $a_2$, ... $a_n$ are set in accordance with digital input signals. A function "1" contact is closed when the applied digital signal is a "1" signal, whilst a function "0" contact is closed when the applied digital signal is a "0" signal. An output analog signal V is produced at a terminal X as a result of a digital to analog conversion effected by the resistor ladder network with the switching elements. The value of V is expressed as follows.

$$V = [\frac{1}{2}a_1 + \frac{1}{4}a_2 + \frac{1}{8}a_3 + \ldots + \frac{1}{2^{n-1}} \cdot a_{n-1} + \frac{1}{2^n} \cdot a_n] \cdot V_{ref} \qquad (1)$$

In this equation (1), the value of each of $a_1$, $a_2$, ... $a_n$ is "1" when the switching element in question is connected with the $V_{ref}$, and "0" when the switching element in question is connected to ground.

The output impedance $Z_{out}$ at the output terminal X of the D/A converter of Fig. 1 is equal to R. The full-scale value $V_f$ of the output voltage of the D/A converter of Fig. 1 is obtained when all of the switching elements $a_1$, $a_2$, ... $a_n$ are in the "1" state, i.e. the value of the input signal is the maximum value. The value $V_f$ is expressed as follows.

$$V_f = \frac{2^n - 1}{2^n} \cdot V_{ref} \qquad (2)$$

In the D/A converter of Fig. 1, it is necessary to vary the full-scale value $V_f$ corresponding to the use of the D/A converter. In the prior art devices, the full-scale value $V_f$ is varied in the analog manner.

However, such a prior art device is disadvantageous because it is necessary to provide another D/A converter which produces a variable $V_{ref}$ signal which is supplied to the D/A converter of Fig. 1 in order to carry out analog control of the full-scale value $V_f$, and hence this prior art D/A converter device becomes very complicated.

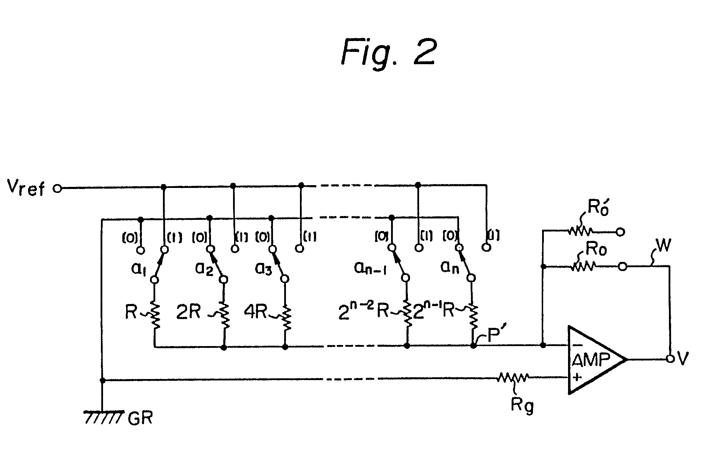

Another prior art D/A converter of the resistor network type is illustrated in Fig. 2. One terminal of each of a sequence of resistors of resistance value R, 2R, 4R, ... $2^{n-2}R$ and $2^{n-1}R$ is joined to the other at a terminal P'. Tve other terminal of each of said sequence of resistors is connected to a fixed contact of a corresponding switching element $a_1$, $a_2$, ... $a_n$. A function "0" contact of each of the switching elements is connected to ground GR, while a function "1" contact of each said switching element is connected to the reference voltage source $V_{ref}$. The joined terminal P' of the resistors is connected with one input of a current-to-voltage conversion amplifier AMP. The other input of the amplifier Amp is connected to ground GR via a resistor Rg. A feedback resistor $R_0$ is connected across said amplifier AMP. The current-to-voltage conversion ratio is varied by switching said feedback resistor $R_0$ to another feedback resistor $R_0'$. Accordingly, the full-scale value of the D/A converter of Fig. 2 is controlled

by selecting the resistance of the feedback resistor $R_0$ or $R_0'$ connected across the amplifier AMP.

The value of the output voltage V is expressed as follows.

$$V = -(\frac{1}{2}a_1 + \frac{1}{4}a_2 + \frac{1}{8}a_3 + \ldots + \frac{1}{2^n}a_n) \cdot \frac{R_0}{R} \cdot V_{ref} \qquad (3)$$

However, such a prior art device is disadvantageous because it is difficult to carry out the automatic switching of said feedback resistors $R_0$ and $R_0'$ using a digital signal and it is necessary to carry out the change of the connection of a connecting conductor W which connects the output of the amplifier AMP to one of the feedback resistors $R_0$ and $R_0'$. This method of control of the full-scale value of the D/A converter of Fig. 2 is time-consuming and inconvenient.

Further examples of prior art D/A converters of the resistor ladder network type are disclosed in the following publications.

(1) "Ferranti" Semiconductors, Integrated Circuits Data Book: "D-A/A-D Converter Zn 425", Page 28, Fig. 2.

(2) "Data Acquisition Products" Catalog: "CMOS 10-bit, Buffered Multiplying D/A Converter", Page 309, Fig. 1.

An object of the present invention is to provide an A/D conversion system in which the above-mentioned problem is alleviated by providing means to vary the full-scale voltage of the ladder network, whereby the output impedance of the D/A converter is reduced for low levels of input voltage.

According to one aspect of the present invention, there is provided an analog-to-digital (A/D) conversion system comprising a comparator for receiving an analog input signal at one of its input terminals and for producing an output, a register for producing binary data in response to the output of the comparator, a digital-to-analog (D/A) converter including a resistor ladder network comprising a plurality of series-connected first resistors and a plurality of shunt second resistors; and switching elements connected to respective ones of the second resistors and controlled in accordance with the binary data from the register, whereby the D/A converter feeds to the comparator an analog output corresponding to the binary data from the register so that the binary data are successively changed by the register in such a manner that the voltage of the output of the D/A converter becomes equal to the voltage of the analog input signal; characterised in that a full-scale switching circuit including a full-scale control resistor is provided across the output of the D/A converter; and in that the full-scale switching circuit is controlled by a digital switching signal corresponding to the binary data from the register for selecting the resistance value of the full-scale control resistor whereby the output of the D/A converter is controlled by both the ladder network and the full-scale switching circuit.

According to another aspect of the invention, there is provided a D/A converter including a resistor ladder network in which a plurality of first resistors of resistance value R is connected in series between a first terminal and a second terminal, one terminal of each of a plurality of second resistors of resistance value 2R is connected to the first terminal, the second terminal and junction points of the first resistors, respectively, and a further resistor of resistance value 2R is connected between the second terminal and ground; and in which a plurality of switching elements is connected to respective ones of the other terminals of the second resistors, each of the switching elements having a switchable contact connected to a reference voltage source and another switchable contact connected to ground, an analog output signal being obtained from the first terminal by controlling the switching elements by a digital input signal; characterised in that a full-scale switching circuit including a full-scale control resistor is provided between the first terminal and ground; and in that the full-scale switching circuit is controlled by a digital switching signal for selecting the resistance value of the full-scale control resistor.

Embodiments of the invention will now be described, by way of example, with reference to the accompanying drawings, in which:

Figs. 1 and 2 illustrate two examples of prior art D/A converters of the resistor network type, as described above.

Fig. 3 illustrates a D/A converter for use in an embodiment of the present invention,

Fig. 4 illustrates a modification of the full-scale switching circuit used for the D/A converter of Fig. 3,

Fig. 5 illustrates an A/D conversion device to which the D/A converter of Fig. 3 can be applied in accordance with the invention, and

Fig. 6 illustrates an operation of the A/D conversion device of Fig. 5.

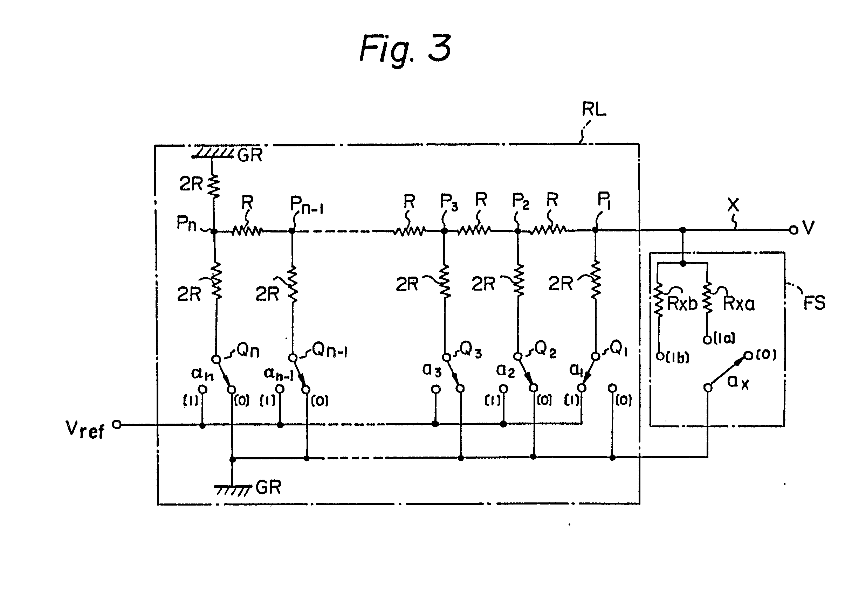

A D/A converter in accordance with an embodiment of the present invention is illustrated in Fig. 3. In the D/A converter of Fig. 3, the "n−1" first resistors of resistance value R are connected in series between the first terminal $P_1$ and the second terminal $P_n$, the connection points $P_2$, $P_3$, ... $P_{n-1}$ being formed between adjacent resistors of resistances value R. Terminals at one end of the "n" second resistors of resistance value 2R are connected with the first terminal $P_1$, the connection points $P_2$, $P_3$, ... $P_{n-1}$ and the second terminal $P_n$, respectively. Another resistor of resistance value 2R is connected between the second terminal $P_n$ and ground GR. Terminals $Q_1$, $Q_2$, ... $Q_n$, at the other end of said "n" resistors of resistance value 2R are connected with fixed contacts of switching elements $a_1$, $a_2$ ... $a_n$. Switchable contacts of each of the switching elements $a_1$, $a_2$, ... $a_n$ consist of the function "1" contact which is connected with the reference voltage $V_{ref}$ and the function "0" contact which is connected with a ground. Semiconductor switching elements may be used for the switching elements $a_1$, $a_2$, ... $a_n$. The switching elements $a_1$, $a_2$, ... $a_n$ are switched in accordance with digital input signals. The function "1" contact is closed when the applied digital signal is signal "1", while the function "0" contact is closed when the applied digital signal is signal "0". The output analog signal V is produced at a terminal X as a result of a digital-to-analog conversion effected by a resistor ladder network RL with the switching elements $a_1$, $a_2$, ... $a_n$.

In the D/A converter of Fig. 3, a full-scale switching circuit FS is connected between the terminal X and ground GR. The full-scale switching circuit FS consists of full-scale control resistors $R_{xa}$ and $R_{xb}$ and a switching element $a_x$ which is controlled by a full-scale switching digital signal. When either a contact 1a or a contact 1b is closed, the value of the output voltage V is expressed as follows where the value $V_{out}$ represents the above indicated equation (1).

$$V = \frac{R_x}{R + R_x} \cdot V_{out} \qquad (4)$$

When both of the contacts 1a and 1b are opened so that the state of the switching element $a_x$ is OFF, the value of the output voltage V is as follows.

$$V = V_{out} \qquad (5)$$

It should be noted that the output impedance of the resistor ladder network RL is equal to the resistance value R.

If the values of the resistors $R_{xa}$ and $R_{xb}$ are selected as R and R/3, respectively, the output voltage V while the contact 1a is closed is

$$\frac{1}{2} \cdot V_{out}$$

and the output voltage V while the contact 1b is closed is

$$\frac{1}{4} \cdot V_{out}$$

Hence, the full-scale value of the D/A converter of Fig. 3 can be varied in accordance with the switching between "0", 1a and 1b. Since this switching is effected in a digital manner, i.e. step by step, the change of the full-scale value of the D/A converter of Fig. 3 is effected in a digital manner.

Although in the above embodiment two full-scale control resistors $R_{xa}$ and $R_{xb}$ are provided, it is possible to select just one or any number of full-scale control resistors.

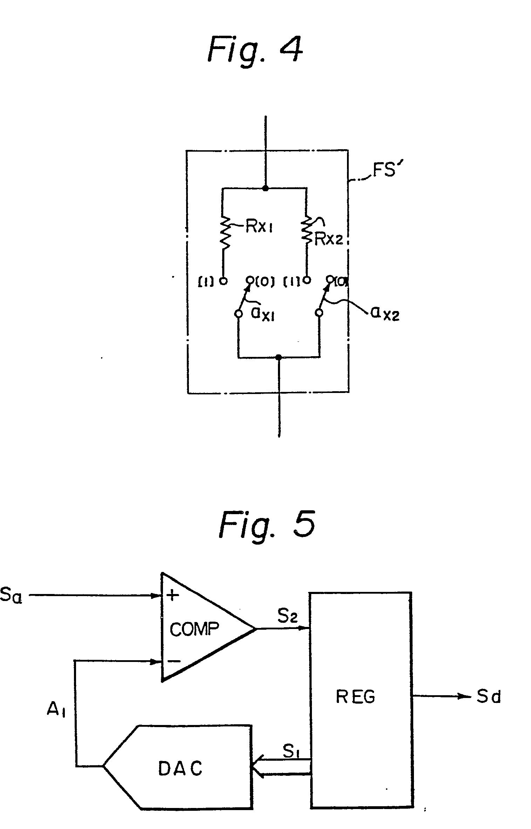

A modified embodiment of a full-scale switching circuit FS' is illustrated in Fig. 4. This switching circuit FS' consists of parallel circuits of a series connected resistor $R_{x1}$ and a switching element $a_{x1}$ and a series connected resistor $R_{x2}$ and a switching element $a_{x2}$. The resistance values of the $R_{x1}$ and $R_{x2}$ may be selected as R and R/2, respectively. Each of the switching elements $a_{x1}$ and $a_{x2}$ is caused to be in an OFF state corresponding to the control signal "0". When the switching element $a_{x1}$ is supplied with the control signal "1", the resistor $R_{x1}$ is connected between the output terminal X and a ground (Fig. 3). When the switching element $a_{x2}$ is supplied with the control signal "1", the resistor $R_{x2}$ is connected between the output terminal X and a ground (Fig. 3).

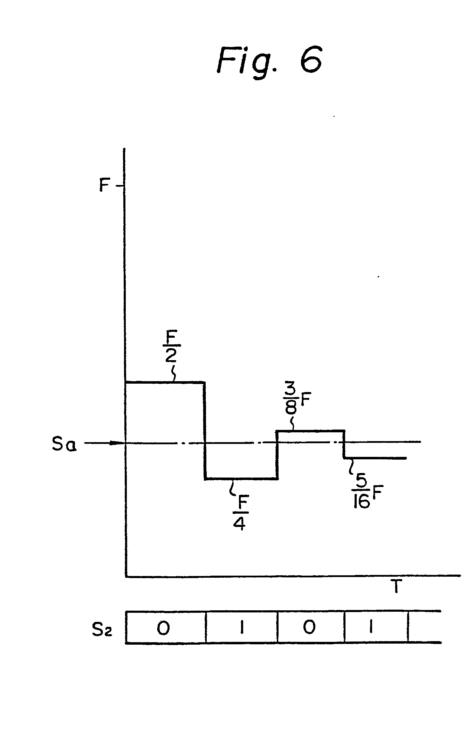

The D/A converter of Fig. 3 can be used in a A/D conversion device of the step-by-step comparison type as illustrated in Fig. 5. The A/D conversion device of Fig. 5 comprises a comparator COMP, a register REG and a D/A converter DAC. An input analog signal $S_a$ and an output $A_1$ of the converter DAC are compared in the comparator COMP. An output $S_2$ is registered in the register REG. The DAC is supplied with a signal $S_1$ from the register REG. The operation of the A/D conversion device of Fig. 5 will be explained with reference to an operation diagram illustrated in Fig. 6. In Fig. 6, the abscissa represents time, and the ordinate represents the output of the converter DAC. At first, $A_1$ is assumed to be F/2, where F is a predetermined value. If the value F/2 is greater than $S_a$, the output $S_2$ of the comparator COMP becomes "0". When the register REG receives this signal "0", the register causes the converter DAC to change the value of the output $A_1$ to the following value.

$$A_1 = \frac{F}{2} - \frac{F}{2} \cdot \frac{1}{2} = \frac{F}{4} \qquad (6)$$

If the value F/4, which is equal to the changed value of $A_1$ is less than $S_a$, the output $S_2$ of the comparator COMP becomes "1". When the register REG receives this signal "1", the register causes the converter DAC to change the value of the output $A_1$ to the following value.

$$A_1 = \frac{F}{4} + \frac{F}{4} \cdot \frac{1}{2} = \frac{3}{8} F \qquad (7)$$

Since the value

$$\frac{3}{8}F$$

is greater than $S_a$, the output $S_2$ of the comparator COMP again becomes "0", so that the value of $A_1$ becomes as follows.

$$A_1 = \frac{3}{8}F - \left(\frac{F}{8}\right) \cdot \frac{,1}{2} = \frac{5}{16}F \qquad (8)$$

After that, the procedure continues in a manner similar to that described above. As a result, the value of the output $S_1$ of the register REG approaches the value corresponding to the input signal $S_a$. A binary number consisting of the sequence of the $S_2$ data "0 1 0 1" illustrated at the bottom of Fig. 6 corresponds to the analog signal $S_a$. This binary number is stored in the register REG. The data stored in the register can be read out as output data $S_d$ from the register. The D/A converter of Fig. 3 in which the full-scale value can be varied as described hereinbefore is suitable for the converter DAC in the A/D conversion system of Fig. 5 because such a variable full-scale characteristic of the converter DAC is advantageous for responding to changes in the magnitude of the input analog signal $s_a$. The response speed of the converter DAC is improved by the reduced output impedance of the converter. Therefore, even if the response speed of the comparator decreases when the system is operated in a low input signal voltage range, the speed of operation of the overall A/D conversion system is not decreased. Furthermore, only a low noise voltage is induced on a conductor connected between the output of the converter DAC and the input of the comparator COMP, because the output impedance of the converter DAC is low when the converter is operated in the low input voltage range.

## Claims

1. An analog-to-digital (A/D) conversion system comprising a comparator (COMP) for receiving an analog input signal (Sa) at one of its input terminals and for producing an output ($S_2$), a register (REG) for producing binary data ($S_1$) in response to the output ($S_2$) of the comparator, a digital-to-analog (D/A) converter (DAC) including a resistor ladder network comprising a plurality of series-connected first resistors and a plurality of shunt second resistors; and switching elements ($Q_1-Q_n$) connected to respective ones of the second resistors and controlled in accordance with the binary data from the register, whereby the D/A converter feeds to the comparator an analog output ($A_1$) corresponding to the binary data from the register so that the binary data are successively changed by the register in such a manner that the voltage of the output ($A_1$) of the D/A converter becomes equal to the voltage of the analog input signal (Sa); characterised in that a full-scale switching circuit (FS) including a full-scale control resistor ($R_x$) is provided across the output of the D/A converter; and in that the full-scale switching circuit is controlled by a digital switching signal corresponding to the binary data from the register for selecting the resistance value of the full-scale control resistor ($R_x$) whereby the output of the D/A converter is controlled by both the ladder network and the full-scale switching circuit.

2. A system as claimed in claim 1, characterised in that a selective switching operation of the full-scale switching circuit (FS) comprises a switch-off operation.

3. A system as claimed in claim 1 or claim 2, characterised in that the full-scale switching circuit (FS) comprises a switching element ($a_x$) having a variable contact which is connected to the full-scale control resistor ($R_x$).

4. A D/A converter including a resistor ladder network in which a plurality of first resistors of resistance value R is connected in series between a first terminal ($P_1$) and a second terminal ($P_n$), one terminal of each of a plurality of second resistors of resistance value 2R is connected to the first terminal, the second terminal and junction points ($P_2-P_{n-1}$) of the first resistors, respectively, and a further resistor of resistance value 2R is connected between the second terminal ($P_n$) and ground (GR); and in which a plurality of switching elements ($Q_1-Q_n$) is connected to respective ones of the other terminals of the second resistors, each of the switching elements having a switchable contact (1) connected to a reference voltage source ($V_{ref}$) and another switchable contact (0) connected to ground, an analog output signal being obtained from the first terminal by controlling the switching elements by a digital input signal; characterised in that a full-scale switching circuit (FS) including a full-scale control resistor ($R_x$) is provided between the first terminal ($P_1$) and ground (GR); and in that the full-scale switching circuit is controlled by a digital switching signal for selecting the resistance value of the full-scale control resistor ($R_x$).

5. A D/A converter as claimed in claim 4, characterised in that a selective switching operation of the full-scale switching circuit (FS) comprises a switch-off operation.

6. A D/A converter as claimed in claim 4 or claim 5, characterised in that the full-scale switching circuit (FS) comprises a switching element ($a_x$) having a variable contact which is connected to the full-scale control resistor ($R_x$).

7. A D/A converter as claimed in claim 4 or claim 5, characterised in that the full-scale switching circuit comprises full-scale control resistors ($R_{x1}$, $R_{x2}$) and switching elements ($a_{x1}$, $a_{x2}$), each of the variable contacts of each of the switching elements being connected to a respective one of the full-scale control resistors.

## Revendications

1. Système de conversion analogique-numérique A/D, comportant un comparateur COMP qui reçoit un signal analogique d'entrée (Sa) à l'une de ces bornes d'entrée et qui produit un signal de sortie ($S_2$), un registre (REG) qui produit des données binaires ($S_1$) en réponse au signal de sortie ($S_2$) du comparateur, un convertisseur numérique analogique (DAC) comprenant un réseau en échelle à résistances constitué par plusieurs premières résistances connectées en série et plusieurs secondes résistances en parallèle; et des éléments de commutation ($Q_1-Q_n$) connectés à certaines respectives des secondes résistances et commandés en fonction des données binaires provenant du registre, de manière que le convertisseur numérique-analogique fournisse au comparateur un signal de sortie analogique ($A_1$) correspondant aux données binaires provenant du registre, et pour que les données binaires soient changées successivement par le registre de manière que la tension de la sortie ($A_1$) dui convertisseur numérique-analogique devienne égale à la tension du signal analogique d'entrée ($S_a$); caractérisé en ce qu'un circuit de commutation de valeur maximale (FS) comprenant une résistance de commande de valeur maximale ($R_x$) est prévu aux bornes de la sortie du convertisseur numérique-analogique; et en ce que le circuit de commutation de valeur maximale est commandé par un signal de commutation numérique correspondant aux données binaires provenant du registre pour commander la valeur de la résistance de commande de valeur maximale ($R_x$) de manière que la sortie du convertisseur numérique-analogique soit commandée à la fois par le réseau en échelle et le circuit de commutation de valeur maximale.

2. Système selon la revendication 1, caractérisé en ce qu'une opération de commutation sélective du circuit de commutation de valeur maximale (FS) consiste en une opération de coupure.

3. Système selon la revendication 1 ou 2, caractérisé en ce que le circuit de commutation de valeur maximale (FS) comporte un élément de commutation ($a_x$) ayant un contact variable qui est connecté à la résistance de commande de valeur maximale ($R_x$).

4. Convertisseur numérique-analogique comprenant un réseau en échelle à résistances dans lequel plusieurs premières résistances de valeur R sont connectées en série entre une première borne ($P_1$) et une seconde borne ($P_n$), une borne de chacune desdites plusieurs secondes résistances de valeur 2R étant connectées respectivement à la première borne, à la seconde borne et aux points de jonction ($P_2$, $P_{n-1}$) des premières résistances et une autre résistance de valeur 2R connectées entre la seconde borne ($P_n$) et la masse ($G_R$); et dans lequel plusieurs éléments de commutation ($Q_1-Q_n$) sont connectés à certaines respectives des autres bornes des secondes résistances, chacun des éléments de commutation comprenant un contact commutable (1) connecté à une source de tension de référence ($V_{ref}$) et un autre contact commutable (0) connecté à la masse, un signal analogique de sortie étant obtenu à la première borne en commandant les éléments de commutation par un signal numérique d'entrée; caractérisé en ce qu'un circuit de commutation de valeur maximale (FS) comprenant une résistance de commande de valeur maximale ($R_x$) est prévu entre la première borne ($P_1$) et la masse (GR); et en ce que le circuit de commutation de valeur maximale est commandé par un signal numérique de commutation pour sélectionner la valeur de la résistance de commande de valeur maximale ($R_x$).

5. Convertisseur numérique-analogique selon la revendication 4, caractérisé en ce qu'une opération de commutation sélective du circuit de commutation de valeur maximale (FS) consiste en une opération de coupure.

6. Convertisseur; numérique-analogique selon la revendication 4 ou 5, caractérisé en ce que le circuit de commutation de valeur maximale (FS) consiste en un élément de commutation ($a_x$) ayant un contact variable qui est connecté à la résistance de commande de valeur maximale ($R_x$).

7. Convertisseur numérique-analogique selon la revendication 4 ou 5, caractérisé en ce que le circuit de commutation de valeur maximale comporte des résistances de commande de valeur maximale ($R_{x1}$, $R_{x2}$) et des éléments de commutation ($a_{x1}$, $a_{x2}$), chacun des contacts variables de chacun des éléments de commutation étant connecté à l'une respective des résistances de commande de valeur maximale.

## Patentansprüche

1. Analog-Digital-(A/D)-Wandlersystem mit einem Komparator (COMP) zum Empfang eines analogen Eingangssignals (Sa) an einem von seinen Eingangsanschlüssen und zur Erzeugung eines Ausgangs ($S_2$), einem Register (REG) zur Erzeugung binärer Daten ($S_1$) in Abhängigkeit von dem Ausgang ($S_2$) des Komparators, einem Digital-Analog-(D/A)-Konverter (DAC), der ein Widerstandskettennetzwerk umfaßt, das eine Vielzahl von in Reihe geschalteten ersten Widerständen und eine Vielzahl von im Nebenschluß liegenden zweiten Widerständen umfaßt: und mit Schaltelementen ($Q_1-Q_n$), die mit entsprechenden der zweiten Widerstände verbunden sind und in Übereinstimmung mit den binären Daten von dem Register gesteuert werden, wodurch der D/A-Wandler dem Komparator einen analogen Ausgang ($A_1$) zuführt, welcher den binären Daten von dem Register entspricht, so daß die binären Daten nacheinander durch das Register in solch einer Weise geändert werden, daß die Spannung des Ausgangs ($A_1$) das D/A-Wandlers gleich der Spannung des analogen Eingangssignals (Sa) wird; dadurch gekennzeichnet, daß ein Vollbereichs-Schaltkreis (FS), der einen Vollbereich-Steuerwiderstand ($R_x$) quer an dem Ausgang des D/A-Wandlers vorgesehen ist; und daß der Vollbereich-Schaltkreis durch ein digitales Schaltsignal, welches den binären Daten von dem Register entspricht, gesteuert wird, um den Widerstandswert des Vollbereich-Steuerwiderstandes $(R_x)$ auszuwählen, wodurch der Ausgang des D/A-Wandlers sowohl durch das Kettennetzwerk als auch durch den Vollbereich-Schaltkreis gesteuert wird.

2. System nach Anspruch 1, dadurch gekennzeichnet, daß ein selektiver Schaltbetrieb des Vollbereich-Schaltkreises (FS) einen Abschaltbetrieb umfaßt.

3. System nach Anspruch 1 oder 2, dadurch gekennzeichnet, daß der Vollbereich-Schaltkreis (FS) ein Schaltelement $(a_x)$ mit einem variablen Kontakt umfaßt, welcher mit dem Vollbereich-Steuerwiderstand $(R_x)$ verbunden ist.

4. D/A-Wandler mit einem Widerstandskettennetzwerk, bei welchem eine Vielzahl von ersten Widerständen eines Widerstandswertes R in Reihe zwischen einem ersten K-Anschluss $(P_1)$ und einem zweiten Anschluss $(P_n)$ verbunden ist, ein Anschluss von jedem der Vielzahl von zweiten Widerständen vom Widerstandswert 2R mit dem ersten Anschluss verbunden ist, der zweite Anschluss bzw. Koppelpunkte $(P_2-P_{n-1})$ der ersten Widerstände und ein weiterer Widerstand vom Widerstandswert 2R zwischen dem zweiten Anschluss $(P_n)$ und Erde (GR) angeschlossen sind; und bei welchem eine Vielzahl von Schaltelementen $(Q_1-Q_n)$ mit entsprechenden der anderen Anschlüsse der zweiten Widerstände verbunden sind, wobei jedes der Schaltelemente einen schaltbaren Kontakt (1) hat, der mit einer Referenz-Spannungsquelle $(V_{ref})$ verbunden ist, und einen anderen schaltbaren Kontakt (0), der mit Erde verbunden ist, ein analoges Ausgangssignal von dem ersten Anschluß durch Steuerung der Schaltelemente durch ein digitales Eingangssignal erhalten wird; dadurch gekennzeichnet, daß ein Vollbereich-Schaltkreis (FS) mit einem Vollbereich-Steuerwiderstand $(R_x)$ zwischen dem ersten Anschluss $(P_1)$ und Erde (GR) vorgesehen ist. und daß der Vollbereich-Schaltkreis durch ein digitales Schaltsignal gesteuert wird, um den Widerstandswert des Vollast-Steuerwiderstands $(R_x)$ auszuwählen.

5. D/A-Wandler nach Anspruch 4, dadurch gekennzeichnet, daß ein selektiver Schaltbetrieb des Vollbereich-Schaltkreises (FS) einen Abschaltbetrieb umfaßt.

6. D/A-Wandler nach Anspruch 4 oder 5, dadurch gekennzeichnet, der Vollbereich-Schaltkreis (FS) ein Schaltelement $(a_x)$ umfaßt, das einen variablen Kontakt hat, der mit dem Vollbereich-Steuerwiderstand $(R_x)$ verbunden ist.

7. D/A-Wandler nach Anspruch 4 oder 5, dadurch gekennzeichnet, daß der Vollbereich-Schaltkreis Vollbereich-Steuerwiderstände $(R_{x1}, R_{x2})$ und Schaltelemente $(a_{x1}, a_{x2})$ umfaßt, und jeder der variablen Kontakte von jedem der Schaltelemente mit einem entsprechendem der Vollbereich-Steuerwiderstände verbunden ist.

Fig. 1

*Fig. 2*

0 026 579

Fig. 3

## Fig. 4

## Fig. 5

# Fig. 6